# EUROPÄISCHE PATENTSCHRIFT

(11) **EP 1 190 209 B1**
(45) Veröffentlichungstag und Bekanntmachung des Hinweises auf die Patenterteilung: **26.05.2004**
(21) Anmeldenummer: 00949077.2
(22) Anmeldetag: 02.06.2000
(51) Int. Cl.: G01B 11/06

(54) **VERFAHREN UND VORRICHTUNG ZUR MESSUNG DER SCHICHTDICKE**
METHOD AND DEVICE FOR MEASURING THE THICKNESS OF A LAYER
PROCEDE ET DISPOSITIF POUR MESURER UNE EPAISSEUR DE COUCHE

(30) Priorität: 28.06.1999 DE 19929493; 16.07.1999 DE 19933316
(43) Veröffentlichungstag der Anmeldung: 27.03.2002
(73) Patentinhaber: Fraunhofer-Gesellschaft zur Förderung der angewandten Forschung e.V., 80686 München (DE)
(72) Erfinder: WALLER, Reinhold, D-91338 Igensdorf (DE); SCHNUPP, Ralf, D-91074 Herzogenaurach (DE)
(74) Vertreter: Gagel, Roland, Dr.
(86) Internationale Anmeldenummer: PCT/DE2000/001840
(87) Internationale Veröffentlichungsnummer: WO 2001/001069

(56) Entgegenhaltungen:
- DE-A- 4 338 907
- US-A- 3 994 584
- US-A- 4 009 965
- US-A- 5 759 615

## Beschreibung

Die Erfindung bezieht sich auf ein Verfahren zur Messung der Schichtdicke während eines Schichtabscheideprozesses sowie auf eine Vorrichtung, mit der das Verfahren durchgeführt werden kann.
Die Anwendungsgebiete der vorliegenden Erfindung liegen in allen Bereichen, bei denen die kontinuierliche oder periodische Messung der Schichtdicke während eines Schichtabscheide- oder Adsorptionsprozesses erforderlich oder wünschenswert ist. Ein bevorzugtes Anwendungsgebiet stellt hierbei der Bereich der Halbleiterfertigung dar. Gerade bei Halbleiterfertigungsprozessen ist die exakte Überwachung und Bestimmung der aufgebrachten Schichten von großer Bedeutung. Eine derartige Schichtdickenmessung kann dann zur Prozeßautomatisierung herangezogen werden.

Im Stand der Technik sind zur Messung von Schichtdicken eine Vielzahl von Meßverfahren bekannt, mit denen die Dicke von adsorbierten, abgeschiedenen oder akkumulierten Schichten bestimmt werden kann.
Ein Teil der Verfahren beruht hierbei auf einem Mikrowägeverfahren, das durch Einsatz von Quarzschwingern oder SAW-Sensoren (Surface Acoustic Wave) durchgeführt wird. Bei beiden Sensortypen wird die Abhängigkeit der Resonanzfrequenz von der auf dem Sensor abgeschiedenen Materialschichtdicke ausgewertet. Quarzschwinger werden hierbei bevorzugt beispielsweise in Sputteranlagen zur Bestimmung der abgeschiedenen Masse eingesetzt. SAW-Sensoren finden beispielsweise als Gassensoren Verwendung. Der sensitive Bereich des Sensors ist hierbei mit einer gassorbierenden Schicht versehen. Die Masseveränderung der Schicht durch eine sorbierte Gasmasse führt zu einer Veränderung der Resonanzfrequenz, die mit dem Verfahren erfaßt wird.
Derartige Mikrowägeverfahren haben jedoch den Nachteil, daß das Verhalten der Sensoren auch vom Elastizitätsmodul der abgeschiedenen Zusatzmasse abhängt. Viele Sensoren zeigen zudem eine starke nichtlineare Abhängigkeit von der Temperatur.

Neben diesen Mikrowägeverfahren sind auch akustische Verfahren und Verfahren der Dielektrometrie zur Schichtdickenmessung bekannt. Bei den akustischen Verfahren wird die zu messende Schicht mit einer Schall- bzw. Ultraschallwelle beaufschlagt und deren Laufzeit durch die Schicht gemessen. Die Auflösung von derzeit am Markt verfügbaren Meßgeräten auf Basis akustischer Meßverfahren liegt im Millimeter- bis Mikrometerbereich.
Bei den Verfahren der Dielektrometrie wird ausgenutzt, daß die Kapazität eines Kondensators von der Dielektrizitätskonstante eines im elektrischen Feld des Kondensators angeordneten Materials abhängt. Hierbei wird die zu messende Schicht zwischen die Elektroden eines Kondensators gebracht und aus dessen Kapazitätsänderung die Schichtdicke bestimmt. Dieses Verfahren ist allerdings nur dann geeignet, wenn sich der Wert der Dielektrizitätskonstante des Schichtmaterials wesentlich vom Wert 1 unterscheidet. Ist dies nicht der Fall, so kann die Dielektrometrie nicht zur Bestimmung der Schichtdicke herangezogen werden.

Ein weiterer Nachteil der Dielektrometrie zur Bestimmung der Schichtdicke besteht darin, daß die Dielektrizitätskonstante des Schichtmaterials bekannt sein muß. Weiterhin kann das Verfahren der Dielektrometrie nur bei nichtmetallischen Schichten angewandt werden.

In vielen Bereichen werden auch optische Verfahren zur Schichtdickenbestimmung eingesetzt. Diese Verfahren nutzen beispielsweise Materialparameter der Schicht, wie Transmission, Reflexion, Absorption, Brechung oder Streuung. Beispiele für Verfahren, die insbesondere in der Halbleiterfertigung zur Bestimmung von Schichtdicken eingesetzt werden, sind die Ellipsometrie oder die Spektroskopie.
Das weitere bekannte Verfahren der Laserinterferometrie wird insbesondere zur Überwachung der Ätzrate und Ätztiefe bei Ätzverfahren eingesetzt. Hierbei ist es jedoch erforderlich, daß die zu ätzende transparente Schicht für die eingesetzte Laserwellenlänge transparent ist.

Die DE 43 38 907 beschreibt eine Messeinrichtung zur Bestimmung von Schichtdicken, mit der die geometrische Dicke aufgedampfter oder gesputterter Schichten über lange Zeiträume während des Beschichtungsprozesses gemessen werden kann. Bei dieser Anwendung, die die Rolle-zu-Rolle Bedampfung von Kunststoff-Folien, Papier und Blechen betrifft, wird ein dünner, quer zur Bahnrichtung gespannter Draht taktweise durch die Bedampfungszone geführt und anschließend ausserhalb der Bedampfungszone mit einem Messsensor vermessen. Die Messung erfolgt mittels einem mit fester Frequenz oszillierenden Laserstrahl, dessen Richtung senkrecht zur Drahtrichtung und senkrecht zur Aufdampfrichtung steht. Ein schneller Photosensor misst die Zeit, in welcher der Laserstrahl durch den bedampften Draht unterbrochen wird. Dieser Messwert stellt ein Maß für die Dicke des bedampften Drahtes und damit die Dicke der Bedampfungsschicht dar.
Die US 5,759,615 offenbart ein Verfahren zur Messung der Staub- bzw. Pulverdicke auf einem Werkstück. Hierbei wird während der Pulveraufbringung wiederum ein Draht in der Nähe des Werkstückes angeordnet, dessen Dicke bzw. Dickenzuwachs nach Beendigung des Pulverauftragungsprozesses in einem gesonderten Messbereich vermessen wird. Die Vermessung des Drahtes erfolgt erst nach dem Auftragungsprozess mit einem Schattenwurfverfahren, d.h. nicht während der Beschichtung. Mit der Vorrichtung dieser Druckschrift wird keine Änderung einer Schichtdicke, sondern lediglich die Enddicke des Drahtes mit der aufgebrachten Schicht erfasst.
Beide Verfahren ermöglichen jedoch nicht die kontinuierliche und genaue Messung der Schichtdicke während des Beschichtungsprozesses.
Die US 4,009,965 beschreibt ein Verfahren sowie eine Vorrichtung zur Bestimmung der Dimensionen von Objekten, beispielweise eines Stabes. Bei dem Verfahren werden die beiden sich gegenüberliegenden Begrenzungen des Stabes mit jeweils einem Laserstrahl beaufschlagt und die an den Begrenzungen gebeugten Strahlen über ein Umlenksystem zur Bildung eines Interferenzmusters überlagert. Aus der Intensitätsverteilung wird schließlich der Durchmesser des Stabes ermittelt. Die Druckschrift gibt allerdings keinerlei Hinweise auf die Bestimmung von Schichtdicken.

Die bisher insbesondere im Bereich der Halbleiterfertigung eingesetzten Verfahren bedienen sich jeweils spezifischer Materialparameter, wie Masse, Schallgeschwindigkeit usw., und sind somit nicht zur Messung beliebiger Materialien oder zur Messung von aus unterschiedlichen Materialien bestehenden Schichtsystemen geeignet. Andere bekannte Verfahren erreichen nicht die erforderliche hohe Genauigkeit für den Einsatz in der Halbleitertechnologie.

Die Aufgabe der vorliegenden Erfindung besteht darin, ein Verfahren und eine Vorrichtung zur Messung der Schichtdicke während eines Schichtabscheideprozesses anzugeben, mit denen die Schichtdicke, insbesondere bei Halbleiterfertigungsprozessen, auf einfache Weise unabhängig von den eingesetzten Materialien mit hoher Genauigkeit bestimmt werden kann.

Die Aufgabe wird mit dem Verfahren bzw. der Vorrichtung nach den Patentansprüchen 1 bzw. 8 gelöst. Vorteilhafte Ausgestaltungen des Verfahrens und der Vorrichtung sind Gegenstand der Unteransprüche. Mit der erfindungsgemäßen Vorrichtung lassen sich insbesondere auch weitere Anwendungsfelder, wie sie in den Ansprüchen 13 bis 15 angeführt sind, erschließen.

Bei dem erfindungsgemäßen Verfahren wird das bekannte physikalische Prinzip der Beugung eingesetzt. Hierfür wird ein Beugungsobjekt bereitgestellt, das zumindest zwei sich gegenüberliegende bzw. zueinander parallele beugende Begrenzungen aufweist, deren gegenseitiger Abstand bekannt ist. Dieses Beugungsobjekt wird in einem Prozeßbereich des Schichtabscheideprozesses angeordnet, in dem die zu messende Schicht abgeschieden oder adsorbiert wird, so daß sich auch eine Schicht an den beugenden Begrenzungen des Beugungsobjektes abscheidet oder adsorbiert. Die Schichtdicke, die sich auf dem Beugungsobjekt abscheidet, muß dabei in bekannter Relation zur Schichtdicke stehen, die auf dem zu vermessenden Objekt abgeschieden wird. Im bevorzugten Anwendungsgebiet der Halbleiterfertigung wird das Beugungsobjekt daher in der für die Schichtabscheidung vorgesehenen Prozeßkammer, vorzugsweise in der näheren Umgebung des mit der Schicht zu versehenden Substrates, angeordnet. Beim Abscheideprozeß wird dadurch die Schicht sowohl auf dem Substrat wie auch auf dem Beugungsobjekt abgeschieden.
Bei einer weiteren vorteilhaften Anwendung des Verfahrens befindet sich das Beugungsobjekt vorzugsweise in der Nähe der Innenwandung der Prozeßkammer. Über die Größe der Schichtdicke am Beugungsobjekt, die in bekannter Relation zur Schicht auf der Innenwandung der Prozesskammer steht, kann so der Reinigungszeitpunkt der Kammer, d.h. der Zeitpunkt, bei dem eine Reinigung der Kammer aufgrund einer bestimmten auf der Kammerwand abgeschiedenen Schichtdicke erforderlich wird, automatisch bestimmt werden.
Das Beugungsobjekt wird mit einem kohärenten Lichtstrahl, d.h. einem Laserstrahl, beleuchtet und auf eine Detektionsfläche abgebildet. Dabei müssen sich die beugenden Begrenzungen des Beugungsobjektes im Strahlengang des Laserstrahls befinden. Der Abstand der beugenden Begrenzungen des Beugungsobjektes ist daher so gewählt, daß dieser geringer als der Durchmesser des Laserstrahls ist. Hierfür wird ein langgestrecktes draht- bzw. stabförmiges Gebilde eingesetzt, dessen Durchmesser abhängig von der gewünschten Auflösung und dem Meßbereich gewählt wird und geringer als 500 µm - vorzugsweise ≤ 300 µm - ist.
Die durch Beugung am Beugungsobjekt auf der Detektionsfläche vorliegenden örtliche Intensitätsverteilung des Laserstrahls wird mit einem geeigneten Detektor erfaßt. Aus der durch die Beugung verursachten Intensitätsverteilung wird die jeweils aktuelle Dicke des Beugungsobjektes bestimmt. Diese Dicke ändert sich während der Schichtabscheidung aufgrund der abgeschiedenen bzw. adsorbierten Schicht. Aus dem jeweils aktuell gemessenen Abstand der beugenden Begrenzungen und der bekannten Dicke des Beugungsobjektes, d.h. dem zu Prozeßbeginn vorliegenden bekannten Abstand der sich gegenüberliegenden beugenden Begrenzungen, kann zu jedem Zeitpunkt die jeweils vorliegende Schichtdicke berechnet werden.

Mit dem erfindungsgemäßen Verfahren läßt sich die Dicke von dünnen Schichten während der Schichtabscheidung unabhängig von den Materialparametern mit hoher Genauigkeit erfassen. Das Verfahren ist für einen Meßbereich von Schichtdicken von wenigen Nanometern bis in dem Millimeterbereich geeignet. Im Gegensatz zu den bisher eingesetzten Schichtdickenmeßverfahren, welche die Dicke der Schicht indirekt über spezifische Materialparameter ermitteln, wird mit dem vorliegenden Verfahren die Schichtdicke direkt bestimmt. Das erfindungsgemäße Verfahren ist somit unabhängig von den Materialparametern der zu vermessenden Schicht, wie beispielsweise der Masse, der Dielektrizitätskonstante, der Leitfähigkeit oder der optischen Eigenschaften.
Ein weiterer Vorteil des erfindungsgemäßen Verfahrens und der zugehörigen Vorrichtung liegt darin, daß auch die Abscheidung einer Mehrfachschicht, die sich in entsprechender Weise auch am Beugungsobjekt niederschlägt, ohne Probleme überwacht werden kann.

Ein wesentlicher Vorteil des erfindungsgemäßen Verfahrens liegt in seinem einfachen Aufbau und der hohen Genauigkeit, mit der die Schichtdicken gemessen werden können. Diese Genauigkeit, die im Nanometerbereich liegt, bringt besondere Vorteile gerade beim Einsatz des Verfahrens in der Halbleiterfertigung, beispielsweise in Sputteranlagen, CVD-Anlagen oder Ätzreaktoren. Bei derartigen Anwendungen werden der Laser außerhalb und das Beugungsobjekt innerhalb der Prozeßkammer angeordnet, wobei der Laserstrahl durch ein Fenster in der Prozeßkammer auf das Beugungsobjekt trifft.

Das Verfahren ist auch für den Einsatz in optisch transparenten Flüssigkeiten, wie beispielsweise im Bereich der Galvanik oder Biosensorik, geeignet.
Weiterhin kann mit dem Verfahren über die Schichtdicke das Volumen von Substanzen bestimmt werden, die am Beugungsobjekt sorbieren.

Bei bestimmten Einsatzbereichen des erfindungsgemäßen Verfahrens, bei denen eine Schicht auf einem Objekt abgeschieden oder adsorbiert werden soll, das bereits selbst als Beugungsobjekt im Sinne des erfindungsgemäßen Verfahrens geeignet ist, kann dieses Objekt selbstverständlich direkt als Beugungsobjekt eingesetzt werden. Ein Beispiel für eine derartige Anwendung ist die Beschichtung von Drähten mit Lack (z.B. Kupferlackdraht). Hier kann der zu beschichtende Draht direkt im Laserstrahl angeordnet werden und als Beugungsobjekt dienen.

Die örtliche Intensitätsverteilung auf der Detektionsfläche kann beispielsweise mit einer CCD-Kamera, einer Photodiodenzeile, einem Spiegelscanner oder einem PSD (Position Sensitive Device) erfaßt werden. Es kann eine separate Detektionsfläche vorgesehen sein, aus der die Intensitätsverteilung beispielsweise mittels einer CCD-Kamera ausgelesen wird. Alternativ kann die Detektionsfläche direkt aus dem Detektor, wie beispielsweise einer Photodiodenzeile bestehen.
Als kohärente Lichtquellen kommen insbesondere HeNe-Laser oder Halbbleiter-Laser, vorzugsweise im IR-Bereich, zum Einsatz.

In einer vorteilhaften Ausführungsform des erfindungsgemäßen Verfahrens wird ein weiteres Beugungsobjekt, das die gleichen Voraussetzungen wie das mit der Schicht beaufschlagte Beugungsobjekt aufweist, vorgesehen. Dieses Beugungsobjekt wird in einem aus dem Laserstrahl ausgekoppelten Teilstrahl angeordnet. Die Anordnung erfolgt jedoch in einem Bereich, in dem keine Schicht auf dem Beugungsobjekt abgeschieden oder absorbiert wird, so daß der Abstand der beugenden Begrenzungen nicht durch die Schichtabscheidung beeinflußt wird. Im Falle der Anwendnung im Bereich der Halbleiterfertigung wird dieses Referenzbeugungsobjekt, ebenso wie der Laser selbst, außerhalb der Prozeßkammer angeordnet. Auch dieses Beugungsobjekt wird mit dem Teilstrahl auf eine Detektionsfläche abgebildet und die sich ergebende örtliche Intensitätsverteilung erfaßt. Aus dieser örtlichen Intensitätsverteilung wird der Abstand der beugenden Begrenzungen berechnet und mit dem bekannten Abstand verglichen. Auf diese Weise kann beispielsweise eine Temperaturerhöhung, die zur Veränderung des Abstandes führen würde, quantitativ erfaßt und damit die Berechnung der Schichtdicke korrigiert werden. Hierfür ist es erforderlich, daß beide Beugungsobjekte die gleichen Materialeigenschaften aufweisen. Vorzugsweise bestehen beide Beugungsobjekte daher aus dem gleichen Material und weisen die gleiche Dicke auf.
Die Abbildung der beiden Beugungsobjekte kann auf die gleiche Detektionsfläche erfolgen. Hierbei würde die Messung durch wechselseitiges Abdecken der beiden Teilstrahlen jeweils für das Referenzbeugungsobjekt und für das zu vermessende Beugungsobjekt periodisch nacheinander durchgeführt. Beim Vorsehen unterschiedlicher Detektionsflächen können beide Messungen parallel und kontinuierlich durchgeführt werden.
Mit dieser Ausführungsform ist es auch möglich, eventuelle Schwankungen in der Laserstrahlintensität oder -wellenlänge bei der Berechnung der Schichtdicke zu berücksichtigen.

Die erfindungsgemäße Vorrichtung zur Dickenmessung weist eine kohärente Lichtquelle zur Aussendung eines Lichtbündels sowie eine Detektionsfläche auf, auf die das Lichtbündel gerichtet ist. Zwischen der Lichtquelle und der Detektionsfläche ist ein Beugungsobjekt unbeweglich im Lichtbündel angeordnet, das zumindest zwei sich gegenüberliegende beugende Begrenzungen in bekanntem gegenseitigem Abstand (Anfangsabstand vor Beginn der Messung) aufweist, die sich innerhalb des Lichtbündels befinden. Weiterhin ist ein Detektor zur Erfassung einer örtlichen Verteilung von auf der Detektionsfläche vorliegender Lichtintensität vorgesehen. Der Detektor ist mit einer Auswerteeinrichtung verbunden, die den aktuellen Abstand der beugenden Begrenzungen des Beugungsobjektes bzw., daraus resultierend, die Dicke einer darauf vorliegenden bzw. aufwachsenden Schicht aus der gemessenen Verteilung der Lichtintensität berechnet.
Auf einzelne Komponenten dieser Vorrichtung wurde bereits im Zusammenhang mit dem vorangehend beschriebenen Verfahren näher eingegangen.

Die erfindungsgemäße Vorrichtung läßt sich vorteilhaft als Sensor einsetzen. Hierbei befinden sich zumindest das Beugungsobjekt, die Detektionsfläche und der Detektor auf einem gemeinsamen Träger, der auf einfache Weise an die entsprechenden Meßpositionen gebracht werden kann. Vorzugsweise ist auch der Laser bereits auf dem Träger fixiert.
Weiterhin kann das Beugungsobjekt auch separat in die Umgebung eingebracht werden, in welcher der zu messende Effekt, z.B. eine Beschichtung, ein Abtrag, oder eine Adsorption, auftritt. Das Beugungsobjekt wird anschließend nur für die Auswertung in eine Vorrichtung bestehend aus der kohärenten Lichtquelle, der Detektionsfläche, dem Detektor und der Auswerteeinrichtung, eingesetzt.

In einer vorteilhaften Ausführungsform umfaßt diese Vorrichtung auch ein weiteres Beugungsobjekt in einem vom ausgesandten Lichtbündel ausgekoppelten Teilbündel. Hierbei ist die Auskopplung und somit der Abstand des weiteren Beugungsobjektes vom ersten Beugungsobjekt variabel gestaltet, so daß sich die Vorrichtung den entsprechenden Anforderungen, beispielsweise einer Prozeßkammer, anpassen läßt. Insbesondere muß es die Vorrichtung ermöglichen, daß das Referenzobjekt in einem ausreichenden Abstand vom ersten Beugungsobjekt angeordnet werden kann, so daß das Referenzobjekt beim Einsatz nicht beschichtet wird.

Die erfindungsgemäße Vorrichtung läßt sich neben dem Einsatz bei der Schichtdickenmessung in der Halbleiterfertigungstechnik auch auf anderen Gebieten vorteilhaft einsetzen.
So kann die Vorrichtung als Temperatursensor dienen, bei dem eine durch eine Temperaturveränderung hervorgerufene Ausdehnung des Beugungsobjektes im Laserstrahl erfaßt und berechnet wird. Hierfür wird ein Material mit einer vorbestimmten Abhängigkeit der Ausdehnung von der Temperatur eingesetzt.
In gleicher Weise lassen sich mechanische Spannungen eines Objektes erfassen, wenn dieses als Beugungsobjekt in der vorliegenden Vorrichtung eingesetzt wird. Durch die Änderung der mechanischen Spannungen ändert sich die Dicke des Objektes (Querkontraktion in Folge mechanischer Dehnung), so daß dies mit der erfindungsgemäßen Vorrichtung sehr genau erfaßt werden kann.

Weiterhin kann der erfindungsgemäße Sensor zur Bestimmung des Fortschrittes eines Reinigungsprozesses in einer Prozeßkammer herangezogen werden. Insbesondere im Bereich der Schichtabscheidung kann somit einerseits die Dicke der abgeschiedenen Schicht bestimmt, andererseits ein nachfolgender Reinigungsprozeß der Prozeßkammer, der beispielweise mittels eines Ätzgases erfolgt, überwacht werden. Durch diesen Reinigungsprozeß wird die auf dem Beugungsobjekt vorher abgeschiedene Schicht wieder entfernt. Wird keine Schichtdicke auf dem Beugungsobjekt mehr detektiert, so ist dies ein Maß für die Sauberkeit der Prozeßkammer, und der Reinigungsprozeß kann beendet werden. Die Vorrichtung kann in diesem Fall zur Automatisierung des Reinigungsprozesses eingesetzt werden.

Bei einer weiteren Anwendung kann die Vorrichtung zur Untersuchung der Richtungsabhängigkeit der Schichtabscheidung oder Schichtabtragung von Prozessen in einer Prozeßkammer eingesetzt werden. Durch diese Richtungsabhängigkeit vieler Prozesse variiert die Schichtdicke über den Umfang des Beugungsobjektes. Die Variation der Schichtdicke kann durch anschließendes Drehen des Beugungsobjektes im kohärenten Lichtstrahl erfaßt werden.

Das Material des Beugungsobjektes wird entsprechend dem Anwendungsbereich gewählt. So kann zum Nachweis von Sauerstoff, d.h. als O₂-Sensor, eine sauerstoffsensitive Schicht auf dem Beugungsobjekt vorgesehen sein, deren Dickenänderung bestimmt wird.

Die Vorrichtung ist sehr robust, kaum störanfällig und schnell. Insbesondere läßt sich ein derartiges System sehr kostengünstig herstellen und einsetzen. Beim Betrieb der Vorrichtung im Bereich der Halbleiterfertigung wird das Beugungsobjekt entweder nach jeder Messung oder nach Abscheidung mehrerer übereinander liegender Schichten ausgetauscht. Bei Prozessen, bei denen die Prozeßkammer und somit auch das darin befindliche Beugungsobjekt in festen Abständen gereinigt werden, ist ein Austausch nicht erforderlich. Das gleiche gilt im Falle einer thermischen Reinigung des Beugungsobjektes. Diese thermische Reinigung kann beispielsweise durch Beaufschlagung des Beugungsobjektes mit einem elektrischen Strom erfolgen, der zur Erwärmung des Beugungsobjektes führt.

Die erfindungsgemäße Vorrichtung und das erfindungsgemäße Verfahren werden nachfolgend nochmals anhand von Ausführungsbeispielen in Verbindung mit den Figuren näher erläutert. Hierbei zeigen:
- Figur 1: eine Prinzipskizze eines Ausführungsbeispiels der erfindungsgemäßen Vorrichtung; und
- Figur 2: ein Beispiel für die Anordnung der erfindungsgemäßen Vorrichtung in einer Prozeßkammer.

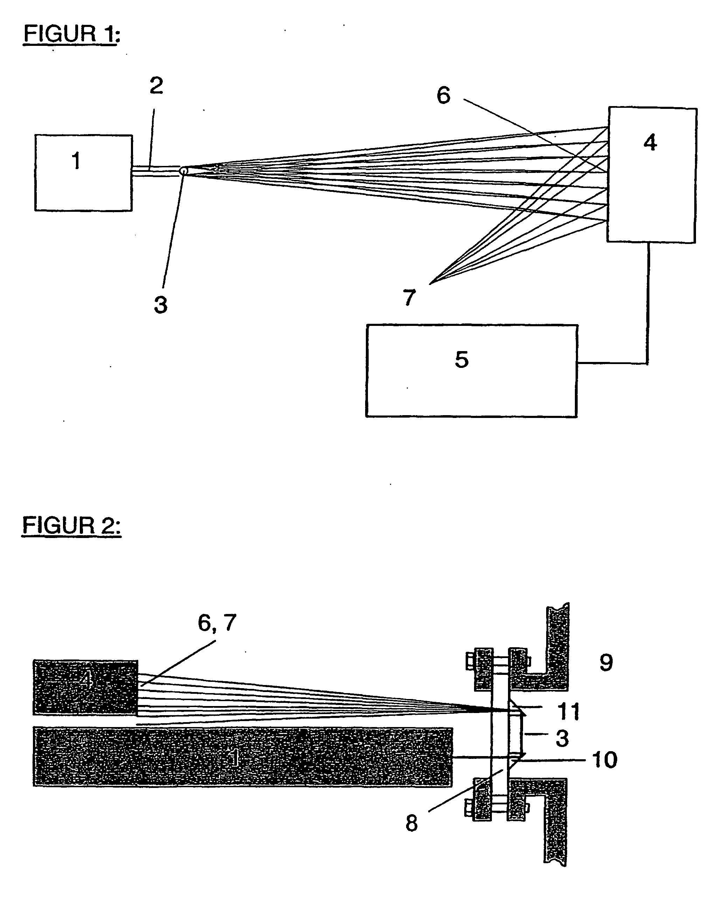

Figur 1 zeigt eine Prinzipskizze eines Ausführungsbeispiels der erfindungsgemäßen Vorrichtung zur Veranschaulichung des erfindungsgemäßen Verfahrens. Die Vorrichtung umfaßt einen Laser 1, der ein paralleles Laserstrahlbündel 2 bekannter Wellenlänge in Richtung auf eine Detektionsfläche, im vorliegenden Beispiel die sensitive Oberfläche einer CCD-Zeilenkamera 4, emittiert. Im Strahlengang des Laserstrahlbündels 2 ist ein Metallstift 3 als Beugungsobjekt bekannter Dicke angeordnet. Der Metallstift hat einen Durchmesser im Bereich von 50 - 200 µm. Das Laserlicht wird an diesem Metallstift gebeugt und erzeugt auf der lichtempfindlichen Fläche der CCD-Zeilenkamera 4 Beugungsmaxima und - minima. Der Abstand dieser Beugungsmaxima und -minima ist von der bekannten Dicke des Metallstiftes, vom bekannten Abstand des Metallstiftes zur Detektionsfläche, der je nach gewünschtem Meßbereich und Auflösung gewählt wird (im vorliegenden Fall ein optischer Weg zwischen 20 und 30 cm), und von der eingesetzten Laserwellenlänge abhängig. Im Zentralbereich der Detektionsfläche tritt in diesem Beispiel das Maximum nullter Ordnung 6 auf, an das sich seitlich die durch Beugung erzeugten Intensitätsmaxima und -minima 7 anschließen. Vorzugsweise werden aus Gründen des Intensitätsunterschiedes nur Nebenmaxima oder Nebenminima ausgewertet.

Zur Durchführung der Messung wird der Metallstift 3 in den Bereich eingebracht, in dem die Schicht abgeschieden wird. Durch die Schichtabscheidung, die auch zu einer abgeschiedenen bzw. adsorbierten Schicht auf der Oberfläche des Metallstiftes führt, verändert sich die Dicke des Metallstiftes und somit die Verteilung der Maxima und Minima 7 im Beugungsmuster auf der Detektionsfläche. Die Verteilung der Beugungsmuster wird zumindest in einer Dimension, vorzugsweise senkrecht zur Anordnung des Metallstiftes 3, mit der Zeilenkamera 4 erfaßt. Hierbei genügt es, mindestens zwei Nebenmaxima oder Nebenminima zu erfassen. die Genauigkeit wird mit der Anzahl der Maxima bzw. Minima erhöht. Die Position der einzelnen Maxima bzw. Minima wird in der Auswerteeinheit 5 mit einem geeigneten Computerprogramm erfaßt, das aus der Lage der Maxima und/oder der Minima, dem Abstand Metallstift - Detektionsfläche, dem anfänglichen Durchmesser des Metallstiftes und der Laserwellenlänge die gerade vorliegende Schichtdicke berechnet.
Die Messung kann hierbei kontinuierlich und in Echtzeit erfolgen. Selbstverständlich können auch nur Einzelmessungen in zeitlichen Abständen während des Schichtabscheideprozesses durchgeführt werden.

Figur 2 zeigt ein Beispiel für die Anordnung der erfindungsgemäßen Vorrichtung in einer Prozeßkammer zur Halbleiterfertigung. Das Beugungsobjekt 3, ein dünner Metallstift, ist in diesem Beispiel in der Nähe des Glasfensters 8 einer Prozeßkammer 9 angeordnet.
Von außerhalb der Prozeßkammer wird mit einem Helium/Neon-Laser 1 ein Laserstrahl durch das Glasfenster 8 in die Prozeßkammer 9 geleitet, dort über ein Ablenkelement, im vorliegenden Fall ein Prisma 10, auf das Beugungsobjekt 3 gerichtet und anschließend über ein weiteres Ablenkelement (Prisma 11) wieder durch das Glasfenster 8 auf eine Auswerteeinheit 4 außerhalb der Prozeßkammer 9 gelenkt. Auf der Auswerteeinheit 4, beispielsweise einer CCD- Zeile, wird die örtliche Intensitätsverteilung, d.h. die Intensitätsmaxima und - minima, des auftreffenden Strahls erfaßt und kann ausgewertet werden. Über die Dicke der auf dem Beugungsobjekt 3 abgeschiedenen Schicht kann auf diese Weise die Dicke der an der Innenwand der Prozeßkammer 9 abgeschiedenen Schicht, beispielsweise die Dicke von an der Wand der Prozeßkammer abgeschiedenen Polymerschichten, bestimmt werden.

## Patentansprüche

1. Verfahren zur Messung der Schichtdicke während eines Prozesses, bei dem eine oder mehrere Schichten auf einem Objekt abgeschieden oder adsorbiert werden, wobei ein Beugungsobjekt (3), das zumindest zwei sich gegenüberliegende beugende Begrenzungen in bekanntem Abstand aufweist, in einem Prozeßbereich angeordnet wird, in dem die zu messende Schicht abgeschieden oder adsorbiert wird, so daß an den beugenden Begrenzungen des Beugungsobjektes (3) eine Schicht abgeschieden oder absorbiert wird, deren Schichtdicke in bekannter Relation zur Schichtdicke auf dem Objekt steht;
**dadurch gekennzeichnet,**
**dass** folgende weitere Schritte durchgeführt werden:
- Abbilden der beugenden Begrenzungen des im Prozeßbereich angeordneten Beugungsobjektes (3) mit einem kohärenten Lichtbündel (2) bekannter Wellenlänge auf eine Detektionsfläche, wobei das Lichtbündel (2) an den beugenden Begrenzungen des Beugungsobjektes (3) gebeugt wird;
- Erfassen einer durch die Beugung verursachten örtlichen Intensitätsverteilung des Lichtbündels (2) auf der Detektionsfläche in zumindest einer Dimension; und
- Berechnen eines aktuellen Abstandes der beugenden Begrenzungen des Beugungsobjektes (3) aus der Intensitätsverteilung und Bestimmung der Schichtdicke aus dem berechneten aktuellen Abstand.

2. Verfahren nach Anspruch 1,
**dadurch gekennzeichnet, daß** ein Beugungsobjekt (3) eingesetzt wird, bei dem der Abstand der sich gegenüberliegenden beugenden Begrenzungen ≤ 300 µm beträgt.

3. Verfahren nach Anspruch 1 oder 2,
**dadurch gekennzeichnet, daß** das Objekt selbst als Beugungsobjekt (3) eingesetzt wird.

4. Verfahren nach einem der Ansprüche 1 bis 3,
**dadurch gekennzeichnet, daß** ein dünner Draht oder Stift als Beugungsobjekt (3) eingesetzt wird.

5. Verfahren nach einem der Ansprüche 1 bis 3,
**dadurch gekennzeichnet, daß** ein Spalt als Beugungsobjekt (3) eingesetzt wird.

6. Verfahren nach einem der Ansprüche 1 bis 5,
**dadurch gekennzeichnet, daß** die örtliche Intensitätsverteilung mit einer CCD-Kamera (4), einer Fotodiodenzeile oder einem Scanner erfaßt wird.

7. Verfahren nach einem der Ansprüche 1 bis 6,
**dadurch gekennzeichnet, daß** ein weiteres Beugungsobjekt, das zumindest zwei sich gegenüberliegende beugende Begrenzungen in bekanntem Abstand aufweist, in einem aus dem kohärenten Lichtbündel (2) ausgekoppelten Teilbündel in einem Bereich angeordnet wird, in dem keine Schicht auf dem weiteren Beugungsobjekt abgeschieden oder adsorbiert wird, wobei die beugenden Begrenzungen des weiteren Beugungsobjektes mit dem Teilbündel auf eine weitere oder die gleiche Detektionsfläche abgebildet, eine auf der weiteren,oder der gleichen Detektionsfläche vorliegende, durch Beugung verursachte örtliche Intensitätsverteilung des Teilbündels in zumindest einer Dimension erfaßt, und der Abstand der beugenden Begrenzungen des weiteren Beugungsobjektes aus der Intensitätsverteilung berechnet werden, so daß bei einer Abweichung des berechneten von dem bekannten Abstand eine entsprechende Korrektur bei der Berechnung berücksichtigt werden kann.

8. Vorrichtung zur Messung von Schichtdicken bei Schichtabscheideprozessen, mit
- einer kohärenten Lichtquelle (1) zur Aussendung eines Lichtbündels (2);
- einer Detektionsfläche, auf die das Lichtbündel (2) gerichtet ist;
- einem zwischen der Lichtquelle (1) und der Detektionsfläche im Lichtbündel (2) unbeweglich angeordneten Beugungsobjekt (3), und
- einem Detektor (4) zur Erfassung einer örtlichen Verteilung von auf der Detektionsfläche vorliegender Lichtintensität in zumindest einer Dimension;
**dadurch gekennzeichnet,**
**dass** das Beugungsobjekt (3) zumindest zwei sich gegenüberliegende beugende Begrenzungen in bekanntem gegenseitigem Anfangsabstand aufweist, die sich innerhalb des Lichtbündels (2) befinden, wobei eine Auswerteeinrichtung (5) vorgesehen ist, die bei einer Änderung des gegenseitigen Abstandes der beugenden Begrenzungen die aktuelle Dicke einer die Änderung bewirkenden auf das Beugungsobjekt (3) aufwachsenden Schicht aus der gemessenen Verteilung der Lichtintensität berechnet.

9. Vorrichtung nach Anspruch 8,
**dadurch gekennzeichnet, daß** die beugenden Begrenzungen des Beugungsobjektes (3) einen Anfangsabstand von ≤ 300 µm aufweisen.

10. Vorrichtung nach Anspruch 8 oder 9,
**dadurch gekennzeichnet, daß** das Beugungsobjekt (3) ein dünner Draht oder Stift ist.

11. Vorrichtung nach einem der Ansprüche 8 oder 10,
**dadurch gekennzeichnet, daß** der Detektor (4) eine CCD-Kamera, eine Fotodiodenzeile oder ein Scanner ist.

12. Vorrichtung nach einem der Ansprüche 8 bis 11,
**dadurch gekennzeichnet, daß** ein weiteres Beugungsobjekt, das zumindest zwei sich gegenüberliegende beugende Begrenzungen aufweist, als Referenzobjekt in einem vom ausgesandten Lichtbündel (2) ausgekoppelten Teilbündel angeordnet ist, so daß eine durch Beugung am Referenzobjekt erhaltene Intensitätsverteilung erfaßt und ausgewertet werden kann.

13. Verwendung der Vorrichtung nach einem der Ansprüche 8 bis 12 bei Reinigungs- oder Ätzprozessen in Prozeßkammern, wobei die Dicke der am Beugungsobjekt (3) vorliegenden Schicht als Maß für den Fortschritt des Reinigungs- oder Ätzprozesses herangezogen wird.

14. Verwendung der Vorrichtung nach einem der Ansprüche 8 bis 12 zur Untersuchung der Richtungsabhängigkeit der Schichtabscheidung oder Schichtabtragung von Prozessen in einer Prozeßkammer (9).

## Claims

1. Method for measuring the thickness of layers during a process in which one or several layers are deposited or adsorbed on an object, wherein a diffraction object (3), which has at least two opposing diffracting limits spaced by a known distance, is positioned in a process zone where the layer to be measured is deposited or adsorbed so that a layer is deposited or adsorbed at said diffracting limits of said diffraction object (3), whose thickness of layer has a known relationship with the thickness of the layer on said object,
**characterised in that** the following further steps are realised:
- projecting said diffracting limits of said diffraction object (3), which is positioned in said process zone, by means of a coherent light pencil (2) of a known wave length onto a detection surface, with said light pencil (2) being diffracted at said diffracting limits of said diffraction object (3);
- detecting a local intensity distribution of said light pencil (2), which is caused by the diffraction, on said detection surface in at least one dimension, and
- computing an actual distance of said diffracting limits of said diffraction object (3) from said intensity distribution and determining the thickness of the layer from the computed actual distance.

2. Method according to Claim 1,
**characterised in that** a diffraction object (3) is used in which the distance of said opposing diffracting limits amounts to ≤ 300 µm.

3. Method according to Claim 1 or 2,
**characterised in that** said object as such is used as diffraction object (3).

4. Method according to any of the Claims 1 to 3,
**characterised in that** a thin wire or a pin is used as diffraction object (3).

5. Method according to any of the Claims 1 to 3,
**characterised in that** a gap is used as diffraction object (3).

6. Method according to any of the Claims 1 to 5,
**characterised in that** said local intensity distribution is detected by means of a CCD camera (4), a photo diode line or a scanner.

7. Method according to any of the Claims 1 to 6,
**characterised in that** a further diffraction object, which has at least two opposing diffracting limits spaced by a known distance, is positioned in a partial pencil coupled out of said coherent light pencil (2) in a zone where no layer is deposited or adsorbed on said further diffraction object, with the diffracting limits of said further diffraction object being projected by said partial pencil onto a further or the same detection surface, wherein a local intensity distribution of said partial pencil, which is present on said further or the same detection surface and is caused by diffraction, is detected in at least one dimension, and wherein the distance of said diffracting limits of said further diffraction object is computed from the intensity distribution so that in the case of a variation of the computed distance from the known distance an appropriate correction may be considered in the computation.

8. Device for measuring the thickness of layers during layer deposition processes, comprising
- a source (1) of coherent light for emitting a light pencil (2);
- a detection surface onto which said light pencil (2) is directed;
- a diffraction object (3) fixedly disposed between said light source (1) and said detection surface in said light pencil (2), and
- a detector (4) for detecting a local distribution of the light intensity present on said detection surface in at least one dimension;
**characterised in**
**that** said diffraction object (3) has at least two opposing diffracting limits spaced by a known distance, which are positioned within said light pencil (2), wherein an analyser means (5) is provided which, when the mutual spacing of said diffracting limits varies, computes the actual thickness of a layer inducing the variation and growing on said diffraction object (3), from the measured distribution of the light intensity.

9. Device according to Claim 8,
**characterised in that** said diffracting limits of said diffraction object (3) have an initial distance of ≤ 300 µm.

10. Device according to Claim 8 or 9,
**characterised in that** said diffraction object (3) is a thin wire or a pin.

11. Device according to any of the Claims 8 or 10,
**characterised in that** said detector (4) is a CCD camera, a photo diode line or a scanner.

12. Device according to any of the Claims 8 to 11,
**characterised in that** a further diffraction object, which has at least two opposing diffracting limits, is disposed as reference object positioned in a partial pencil coupled out from said emitted light pencil (2) so that an intensity distribution obtained by diffraction on said reference object can be detected and analysed.

13. Application of the device according to any of the Claims 8 to 12 in cleaning or etching processes in process chambers, with the thickness of the layer present on said diffraction object (3) serving as a measure of the progress of said cleaning or etching process.

14. Application of the device according to any of the Claims 8 to 12 for studying the dependence of layer deposition or layer removal, in terms of direction, on processes in a process chamber (9).

## Revendications

1. Procédé à mesurer l'épaisseur d'une couche au cours d'un processus, dans lequel une ou plusieurs couches sont déposée ou adsorbées sur un objet, ledit objet de diffraction (3), qui comprend au moins deux limitations diffringentes opposées l'une à l'autre à un écart connu, étant disposé dans une zone de processus, dans laquelle la couche à mesurer est déposée ou adsorbée, d'une telle façon, qu'une couche soit déposée ou adsorbée aux limitations diffringentes dudit objet de diffraction (3), dont l'épaisseur de couche présent une relation connue à l'épaisseur de couche sur l'objet ;
**caractérisé en ce**
**que** les étapes supplémentaires suivantes sont réalisées :
- projection de l'image desdites limitations diffringentes dudit objet de diffraction (3) disposé dans ladite zone de processus, moyennant un faisceau lumineux cohérent (2) à une longueur connue d'ondes, sur une aire de détection, ledit faisceau lumineux (2) subissant une diffraction auxdites limitations diffringentes dudit objet de diffraction (3) ;
- détection d'une distribution locale d'intensités dudit faisceau lumineux (3), qui est causée par la diffraction, sur ladite aire de détection en au moins une dimension ; et
- calcul d'un écart actuel desdites limitations diffringentes dudit objet de diffraction (3) en le dérivant de la distribution d'intensités et établissement de l'épaisseur de ladite couche en la dérivant de l'écart actuel calculé.

2. Procédé selon la revendication 1,
**caractérisé en ce qu'**un objet de diffraction (3) est employé, avec lequel l'écart desdites limitations diffringentes opposées correspond à ≤ 300 µm.

3. Procédé selon la revendication 1 ou 2,
**caractérisé en ce que** l'objet même est employé en tant que l'objet de diffraction (3).

4. Procédé selon une quelconque des revendications 1 à 3,
**caractérisé en ce qu'**un fil ou pointe mince est employé en tant que l'objet des diffraction (3).

5. Procédé selon une quelconque des revendications 1 à 3,
**caractérisé en ce qu'**une fente est employé en tant que l'objet de diffraction (3).

6. Procédé selon une quelconque des revendications 1 à 5,
**caractérisé en ce que** la distribution locale d'intensités est détectée moyennant une caméra CCD (4), une rangée de photodiodes ou un scanneur.

7. Procédé selon une quelconque des revendications 1 à 6,
**caractérisé en ce qu'**un objet supplémentaire de diffraction, qui comprend au moins deux limitations diffringentes opposées l'une à l'autre à un écart connu, est disposé dans un faisceau partiel sorti dudit faisceau de lumière cohérente (2) dans une zone, o'z une couche n'est pas déposée ou adsorbée sur ledit objet supplémentaire de diffraction, à l'image desdites limitations diffringentes dudit objet supplémentaire de diffraction étant projetée, moyennant ledit faisceau partiel, sur une autre ou la même aire de détection, à une distribution locale d'intensité dudit faisceau partiel, qui est présent sur ladite autre ou même aire de détection et qui est causée par la diffraction, étant détectée en au moins une dimension, et à l'écart desdites limitations diffringentes dudit autre objet de diffraction étant calculé par dérivation de la distribution d'intensités d'une telle manière, qu'en cas d'une variation de l'écart calculé de l'écart connu, on puisse prendre une correction appropriée en considération dans le calcul.

8. Dispositif à mesurer l'épaisseur d'une couche au cours d'un processus de dépôt des couches, comprenant
- une source de lumière cohérente (1) à radier un faisceau lumineux (2) ;
- une aire de détection, sur laquelle ledit faisceau lumineux (2) est dirigé ;
- un objet de diffraction (3) disposé de manière immobile entre ladite source luminescente (1) et ladite aire de détection dans ledit faisceau lumineux (2), et
- un détecteur (4) à détecter une distribution locale de l'intensité de lumière présente sur ladite aire de détection, en au moins une dimension ;
**caractérisé en ce que** ledit objet de diffraction (3) comprend au moins deux limitations diffringentes opposées à un écart connu l'une de l'autre, qui se trouvent au-dedans dudit faisceau lumineux (2), à un moyen d'évaluation (5) étant disposé, qui, au cas d'une variation de l'écart desdites limitations diffringentes l'une de l'autre, calcule l'épaisseur actuelle d'une couche croissant sur ledit objet de diffraction (3) en la dérivant de la distribution mesurée de l'intensité de la lumière.

9. Dispositif selon la revendication 8,
**caractérisé en ce que** lesdites limitations dudit objet de diffraction (3) présentent un écart initial de ≤ 300 µm.

10. Dispositif selon la revendication 8 ou 9,
**caractérisé en ce que** ledit objet de diffraction (3) est un fil ou une pointe mince.

11. Dispositif selon une quelconque des revendications 8 ou 10,
**caractérisé en ce que** ledit détecteur (4) est une caméra CCD, une rangée de photodiodes ou un scanneur.

12. Dispositif selon une quelconque des revendications 8 à 11,
**caractérisé en ce qu'**un objet supplémentaire de diffraction, qui comprend au moins deux limitations diffringentes opposées l'une à l'autre, est disposé en tant qu'un objet de référence dans un faisceau partiel sorti dudit faisceau lumineux radié (2), d'une telle manière, qu'on puisse détecter et évaluer une distribution d'intensités obtenue par diffraction audit objet des référence.

13. Emploi du dispositif selon une quelconque des revendications 8 à 12, dans des processus de nettoyage ou de gravure dans des chambres des processus, dans lesquels l'épaisseur de la couche présente audit objet de diffraction (3) est utilisé en tant que mesure du progrès du processus de nettoyage ou de gravure.

14. Emploi du dispositif selon une quelconque des revendications 8 à 12, pour l'étude de la dépendance du dépôt de la couche ou de l'enlèvement d'une couche de la direction, dans des processus dans une chambre de processus (9).
